# EUROPÄISCHE PATENTANMELDUNG

(11) **EP 2 416 371 A2**
(43) Veröffentlichungstag der Anmeldung: **08.02.2012**
(21) Anmeldenummer: 11175716.7
(22) Anmeldetag: 28.07.2011
(51) Int. Cl.: H01L 31/0224

(54) **Dünnschichtsolarzelle und Verfahren zu ihrer Herstellung**

(30) Priorität: 02.08.2010 DE 102010038796
(71) Anmelder: VON ARDENNE ANLAGENTECHNIK GMBH, 01324 Dresden (DE)
(72) Erfinder: Dimer, Martin, 01309 Dresden (DE); Schössler, Tina, 01277 Dresden (DE); Knoth, Thomas, 01277 Dresden (DE); Sturm, Ralf, 01127 Dresden (DE); Graupner, Uwe, 01187 Dresden (DE); Thumsch, Martin, 01324 Dresden (DE); Hecht, Hans-Christian, 01689 Weinböhla (DE)
(74) Vertreter: Lippert, Stachow & Partner

(57) **Zusammenfassung**

Der Erfindung, die eine Dünnschichtsolarzelle mit einem frontseitigen Glassubstrat, einem über dem Glassubstrat angeordneten Frontkontakt, einem über dem Frontkontakt angeordneten Absorber und einem über dem Absorber angeordneten Rückkontakt, worin ein TCO-Schichtsystem aus einer über dem Substrat abgeschiedenen intrinsischen TCO-Schicht und einer darüber angeordneten dotierten TCO-Schicht vorgesehen ist, sowie ein Verfahren zur Herstellung einer solchen Dünnschichtsolarzelle betrifft, liegt die Aufgabe zugrunde, die Eigenschaften der TCO-Schicht in ihren Eigenschaften Transmission, Reflexion und Absorption zu verbessern. Dies wird dadurch gelöst, dass die TCO-Schicht selbst zweischichtig ausgebildet ist, bestehend aus einer direkt auf der intrinsischen TCO-Schicht abgeschiedenen ersten dotierten TCO-Teilschicht und einer unmittelbar auf der ersten dotierten TCO-Teilschicht abgeschiedenen zweiten dotierten TCO-Teilschicht.

## Beschreibung

Die Erfindung betrifft eine Dünnschichtsolarzelle mit einem frontseitigen Glassubstrat, einem über dem Glassubstrat angeordneten Frontkontakt, einem über dem Frontkontakt angeordneten Absorber und einem über dem Absorber angeordneten Rückkontakt. Darin ist ein TCO-Schichtsystem aus einer über dem Substrat abgeschiedenen intrinsischen TCO-Schicht und einer darüber angeordneten dotierten TCO-Schicht vorgesehen. Die Erfindung betrifft auch ein Verfahren zur Herstellung einer Dünnschichtsolarzelle, bei dem über einem frontseitigen Glassubstrat eine Schicht eines Frontkontakts, über dem Frontkontakt eine Schicht als Absorber und über dem Absorber ein Rückkontakt abgeschieden wird. Dabei wird in dem Schichtsystem ein TCO-Schichtsystem aus einer über dem Substrat abgeschiedenen intrinsischen TCO-Schicht und einer darüber angeordneten dotierten TCO-Schicht abgeschieden.

Solarzellen werden als so genannte Dünnschichtzellen oder Dünnschichtsolarzellen gefertigt. Diese bestehen aus einem volltransparenten Substrat, insbesondere aus Glas, auf das ein photoaktiver Schichtstapel aufgebracht wird. In der nachfolgenden Beschreibung wird der Schichtstapel über dem Substrat errichtet. Dabei bezieht sich die Darstellung auf die Errichtung des Schichtstapels auf der der Seite des Lichteintritts gegenüberliegenden Seite des Substrats, wobei das Substrat mit seiner dem Lichteintritt zugewandten Seite unten liegt.

Photovoltaische Bauelemente als Dünnschichtsolarzellen in Form von a-Si/µc-Si-Zellen sind in der DE 197 13 215 A1 beschrieben. Dabei ist ein Substrat, welches in der Regel Glas ist, ggf. auf dazwischen liegenden Barriere- oder Saatschichten, mit einer TCO-Schicht versehen, auf der eine Schichtenfolge aus amorphem und mikrokristallinem Silizium angeordnet ist.

Eine wichtige Anforderung an die Schichten in der Photovoltaik ist eine hohe Streuung des Lichts in die absorbierende Zelle. Die Streuung bewirkt eine effektive Verlängerung der im Absorber zurückgelegten Weglänge und somit eine höhere Absorptionswahrscheinlichkeit des einfallenden Lichtes bei gleichzeitig reduzierter Absorberdicke.

Bei einer TCO-Schicht ist optimale Transmission, Leitfähigkeit, Reflexion und Absorption erforderlich. Hierbei besteht bei dem Stand der Technik Handlungsbedarf zur Verbesserung.

Eine Bemühung zur Verbesserung oder Optimierung ist in der US 2009/0126791 A1 erkennbar. Darin wird die TCO-Schicht (TCO = Transparent Conductive Oxide), die als wesentliche Funktion die Elektrode und die Streuschicht realisiert, mehrschichtig aufgebaut, wobei einer substratseitigen Schichtfolge aus intrinsischem TCO und Silber eine darauf angeordnete dotierte TCO-Schicht folgt.

Der Erfindung liegt die Aufgabe zugrunde, die Eigenschaften der TCO-Schicht in ihren Eigenschaften Transmission, Reflexion und Absorption zu verbessern.

Diese Aufgabe wird durch eine Dünnschichtsolarzelle mit den Merkmalen nach Anspruch 1 gelöst. Die Ansprüche 2 bis 6 zeigen günstige Ausgestaltung dieser Dünnschichtsolarzelle. Die Aufgabe wird auch durch ein Verfahren mit den Merkmalen nach Anspruch 7 gelöst. Die Unteransprüche 8 bis 12 zeigen günstige Ausführungen des erfindungsgemäßen Verfahrens.

Die Erfindung soll nachfolgend anhand eines Ausführungsbeispieles näher erläutert werden. In den zugehörigen Zeichnungen zeigt
- Fig. 1: einen schematischen Querschnitt durch die substratnahen, für die Erfindung relevanten Schichten einer erfindungsgemäßen Dünnschichtsolarzelle,
- Fig. 2: die Transmissions-, Reflexions- und Absorptions-Spektren einer AZO-Schicht auf Glassubstrat und
- Fig. 3: die Transmissions-, Reflexions- und Absorptions-Spektren der gleichen AZO-Schicht, abgeschieden im gleichen Beschichtungsprozess, aber auf einem mit i-ZnO beschichteten Glassubstrat.

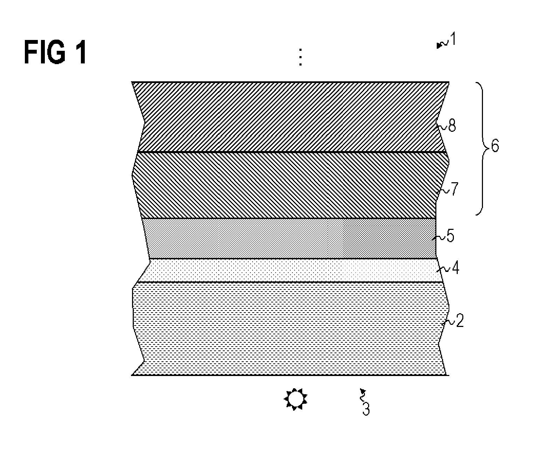

Wie in Fig. 1 dargestellt, weist die Dünnschichtsolarzelle 1 ein Glassubstrat 2 auf. Das Sonnensymbol kennzeichnet die Frontseite 3, d.h. die Seite des Lichteintritts.

Auf der dem Lichteintritt 3 abgewandten Oberfläche des Glassubstrats 2 ist über dem Glassubstrat 2 eine isolierende Barriereschicht 4 angeordnet. Diese kann beispielsweise aus Si₃N₄ bestehen. Darüber ist eine intrinsische TCO-Schicht, in diesem Beispiel eine intrinsische ZnO-Schicht 5, abgeschieden. Darüber befindet sich eine dotierte TCO-Schicht 6. Darüber sind dann das Absorbersystem, ein Rückkontakt und möglicherweise ein Schutzsubstrat vorgesehen, die zur besseren Übersichtlichkeit mit drei Punkten angedeutet, jedoch nicht näher dargestellt sind.

Die TCO-Schicht 6 selbst ist zweischichtig ausgebildet. Sie besteht aus einer direkt auf der intrinsischen TCO-Schicht, der ZnO-Schicht 5, abgeschiedenen ersten dotierten TCO-Teilschicht in Form einer ZnO-A-Schicht 7 und aus einer zweiten dotierten TCO-Teilschicht in Form einer ZnO-B-Schicht 8, wobei "A" und "B" unterschiedliche Dotanden und/oder Dotierungskonzentrationen bezeichnen sollen.

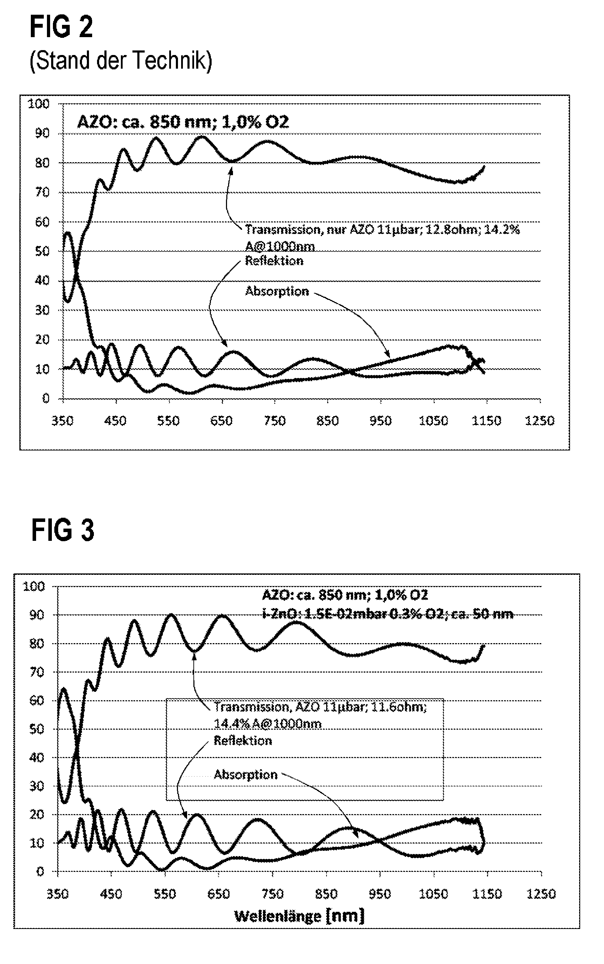

Fig. 2 zeigt die Transmissions-, Reflexions- und Absorptionsspektren einer AZO-Schicht (AZO = Aluminium-Zinkoxid) auf einem Glassubstrat nach dem Stand der Technik. Dies wird mit Fig. 3 den Transmissions-, Reflexions- und Absorptionsspektren einer erfindungsgemäß gestalteten AZO-Schicht auf einem mit einer i-ZnO-Schicht beschichteten Glassubstrat 2 gegenübergestellt. Dabei stellt sich heraus, dass durch eine Schichtenfolge aus einer dünnen i-ZnO-Schicht 5 und einer dotierten zweischichtigen TCO-Schicht 6 in Form einer AZO-Schicht die Eigenschaften des Gesamtschichtsystems, nämlich die Absorption des Gesamtschichtsystems, der Flächenwiderstand und die maximale Transmission sowie die Differenz zwischen Interferenzmaximum und dem darauf folgenden Interferenzminimum der Transmission erhöht werden.

### Bezugszeichenliste

- 1: Dünnschichtsolarzelle
- 2: Glassubstrat
- 3: Lichteintritt
- 4: Barriereschicht
- 5: i-ZnO-Schicht
- 6: dotierte TCO-Schicht
- 7: ZnO-A-Schicht
- 8: ZnO-B-Schicht

## Patentansprüche

1. Dünnschichtsolarzelle mit einem frontseitigen Glassubstrat (2), einem über dem Glassubstrat (2) angeordneten Frontkontakt, einem über dem Frontkontakt angeordneten Absorber und einem über dem Absorber angeordneten Rückkontakt, die ein TCO-Schichtsystem aus einer über dem Substrat (2) abgeschiedenen intrinsischen TCO-Schicht (5) und einer darüber angeordneten dotierten TCO-Schicht (6) aufweist, wobei die dotierte TCO-Schicht (6) selbst zweischichtig ausgebildet ist, bestehend aus einer direkt auf der intrinsischen TCO-Schicht (5) abgeschiedenen ersten dotierten TCO-Teilschicht (7) und einer unmittelbar auf der ersten dotierten TCO-Teilschicht (7) abgeschiedenen zweiten dotierten TCO-Teilschicht (8).

2. Dünnschichtsolarzelle nach Anspruch 1, **dadurch gekennzeichnet , dass** das TCO-Schichtsystem (5, 6) aus ZnO-Schichten (5, 7, 8) aufgebaut ist.

3. Dünnschichtsolarzellen nach Anspruch 1 oder 2, **dadurch gekennzeichnet , dass** die beiden TCO-Teilschichten (7, 8) einen unterschiedlichen Dotierungsgrad und/oder unterschiedliche Dotierungselemente aufweisen.

4. Dünnschichtsolarzelle nach einem der Ansprüche 1 bis 3, **dadurch gekennzeichnet , dass** die gemittelte Absorption im Wellenlängenbereich zwischen 450 und 1100 nm der TCO-Schicht (6) mit den beiden Teilschichten (7, 8) im Vergleich zu einem Schichtsystem ohne die zweite Teilschicht geringer ist.

5. Dünnschichtsolarzelle nach einem der Ansprüche 1 bis 4, **dadurch gekennzeichnet , dass** zwischen der intrinsischen TCO-Schicht (5) und dem Substrat (2) mindestens eine SiOₓN_{y}-, eine SiOₓ- oder eine SiₓN_{y}- Schicht (4) mit 0 < *x* ≤ 2 und 1 ≤ < *x* ≤ 2 eingebaut ist.

6. Dünnschichtsolarzelle nach einem der Ansprüche 1 bis 5, **dadurch gekennzeichnet , dass** die erste (7) und/oder die zweite TCO-Teilschicht (8) mit mindestens einem der Elemente Al, In, Ga, F, Y, Mg oder Bor dotiert ist.

7. Verfahren zur Herstellung einer Dünnschichtsolarzelle (1), bei dem über einem frontseitigen Glassubstrat (2) eine Schicht eines Frontkontakts, über dem Frontkontakt eine Schicht als Absorber und über dem Absorber ein Rückkontakt abgeschieden wird, wobei in dem Schichtsystem ein TCO-Schichtsystem aus einer über dem Substrat abgeschiedenen intrinsischen TCO-Schicht (5) und einer darüber angeordneten dotierten TCO-Schicht (6) abgeschieden wird, und wobei direkt auf der intrinsischen TCO-Schicht (5) eine erste dotierte TCO-Teilschicht (7) und unmittelbar auf der ersten dotierten TCO-Teilschicht (7) eine zweite dotierte TCO-Teilschicht (8) abgeschieden wird.

8. Verfahren nach Anspruch 7, **dadurch gekennzeichnet, dass** das TCO-Schichtsystem (5, 6) aus ZnO-Schichten (5, 7, 8) gebildet wird.

9. Verfahren nach Anspruch 8, **dadurch gekennzeichnet, dass** die ZnO-Schichten (5, 7, 8) mittels DC-, DC-Puls- oder MF-Sputtern von rohrförmigen Targets abgeschieden werden.

10. Verfahren nach einem der Ansprüche 7 bis 9, **dadurch gekennzeichnet , dass** die beiden TCO-Teilschichten (7, 8) mit einem unterschiedlichen Dotierungsgrad und/oder unterschiedlichen Dotierungselementen abgeschieden werden.

11. Verfahren nach einem der Ansprüche 7 bis 10, **dadurch gekennzeichnet , dass** zwischen der intrinsischen TCO-Schicht (5) und dem Substrat (2) mindestens eine SiOₓN_{y}- eine SiOₓ- oder eine SiₓN_{y}-Schicht (4) mit 0 < *x* ≤ 2 und 1 ≤ < *x* ≤ 2 abgeschieden wird.

12. Verfahren nach einem der Ansprüche 7 bis 11, **dadurch gekennzeichnet , dass** die erste (7) und/oder die zweite TCO-Teilschicht (8) mit mindestens einem der Elemente Al, In, Ga, F, Y, Mg oder Bor dotiert wird.
